Europäisches Patentamt

European Patent Office

Office européen des brevets

(11) Veröffentlichungsnummer: **0 238 886**
**A1**

## (12) EUROPÄISCHE PATENTANMELDUNG

(21) Anmeldenummer: 87102834.6

(22) Anmeldetag: 27.02.87

(51) Int. Cl.⁴: **G01R 1/073 , G01R 31/28**

(30) Priorität: 03.03.86 DE 3606877

(43) Veröffentlichungstag der Anmeldung:
30.09.87 Patentblatt 87/40

(84) Benannte Vertragsstaaten:
DE FR GB IT

(71) Anmelder: **Siemens Aktiengesellschaft Berlin
und München**
**Wittelsbacherplatz 2**
**D-8000 München 2(DE)**

(72) Erfinder: **Barth, Wolfram, Dipl.-Ing.(FH)**
**Lukas-Moser-Strasse 7**
**D-7530 Pforzheim(DE)**

(54) Vorrichtung zum Bestücken eines Adapters mit Kontaktnadeln für eine
Leiterplatten-Prüfeinrichtung.

(57) Zum Prüfen von Leiterplatten an in einem Raster liegenden Prüfpunkten, deren Mindestabstand gleich dem doppelten Rastermaß ist, wird ein Zwischenadapter (ZA) verwendet, der je Prüfpunkt eine Bohrung (ZAB) mit einer Kontaktnadel (ND2) aufweist. Vor dem Bestücken des Zwischenadapters (ZA) mit den Kontaktnadeln (ND2) sind diese in einem Magazin (MA) enthalten, das für je vier benachbarte Rasterpunkte eine Zelle (MAZ) mit einer Kontaktnadel (ND1, ND2, ND3) aufweist. Zum Bestücken des Zwischenadapters (ZA) wird auf diesen eine Führungsplatte (FP) und darüber das Magazin (MA) angeordnet. In der Führungsplatte (FP) sind Führungsbohrungen (FBR) enthalten, die über den Bohrungen (ZAB) des Zwischenadapters angeordnet sind und die aus dem Magazin (MA) fallenden Kontaktnadeln (ND2) in die Bohrungen (ZAB) des Zwischenadapters lenken.

Hauptanwendungsgebiet der Erfindung sind Prüfeinrichtungen für Leiterplatten und Flachbaugruppen.

ZAP1

ZAP2

FIG 3

EP 0 238 886 A1

## Vorrichtung zum Bestücken eines Adapters mit Kontaktnadeln für eine Leiterplatten-Prüfeinrichtung

Die Erfindung betrifft eine Vorrichtung gemäß dem Oberbegriff des Anspruchs 1.

Eine Vorrichtung, die aus der DE-PS 29 20 226 bekannt ist, eignet sich nur zum Bestücken von Zwischenadaptern mit Kontaktnadeln in dem Fall, daß der Mindestabstand der Leiterplatten-Prüfpunkte, die in einem Raster liegen, gleich dem Rastermaß ist. Zur Prüfung von Leiterplatten, deren Bohrungen zur Aufnahme von Bauelementen zwar ebenfalls in einem Raster liegen, deren Mindestabstand aber größer, im allgemeinen gleich dem doppelten Rastermaß ist, ist die bekannte Vorrichtung praktisch nicht geeignet, da das Magazin für jeden möglichen Prüfpunkt, d. h. jeden Rasterpunkt, eine Zelle mit einer Kontaktnadel aufweisen müßte, obwohl von vier nebeneinanderliegenden möglichen Prüfpunkten allenfalls nur einer mit einer Prüfnadel kontaktiert werden muß. Außer dem ergäben sich wegen des engen Rasters Schwierigkeiten bei der Herstellung und Handhabung des Adapters.

Der vorliegenden Erfindung liegt die Aufgabe zugrunde, eine Vorrichtung zu schaffen, mit der Zwischenadapter zur Prüfung solcher Leiterplatten und Flachbaugruppen mit Kontaktnadeln bestückt werden können, deren Prüfpunkte einen Mindestabstand haben, der größer als das Rastermaß der möglichen Prüfpunkte ist.

Erfindungsgemäß wird diese Aufgabe mit den im kennzeichnenden Teil des Anspruchs 1 angegebenen Maßnahmen gelöst.

Zwischenadapter, Führungsplatte und Nadelmagazin werden aneinander gebracht, dann zusammen um 180° gedreht, so daß die Kontaktnadeln vom Magazin in den Zwischenadapter fallen können. Anschließend wird das Magazin, zweckmäßig unter Rütteln, angehoben. Entsprechend werden die Kontaktnadeln aus dem Zwischenadapter in das Magazin zurückgebracht.

Anhand der Zeichnung, in der ein Ausführungsbeispiel der Erfindung dargestellt ist, werden im folgenden die Erfindung sowie weitere Ausgestaltungen und Ergänzungen näher beschrieben und erläutert.

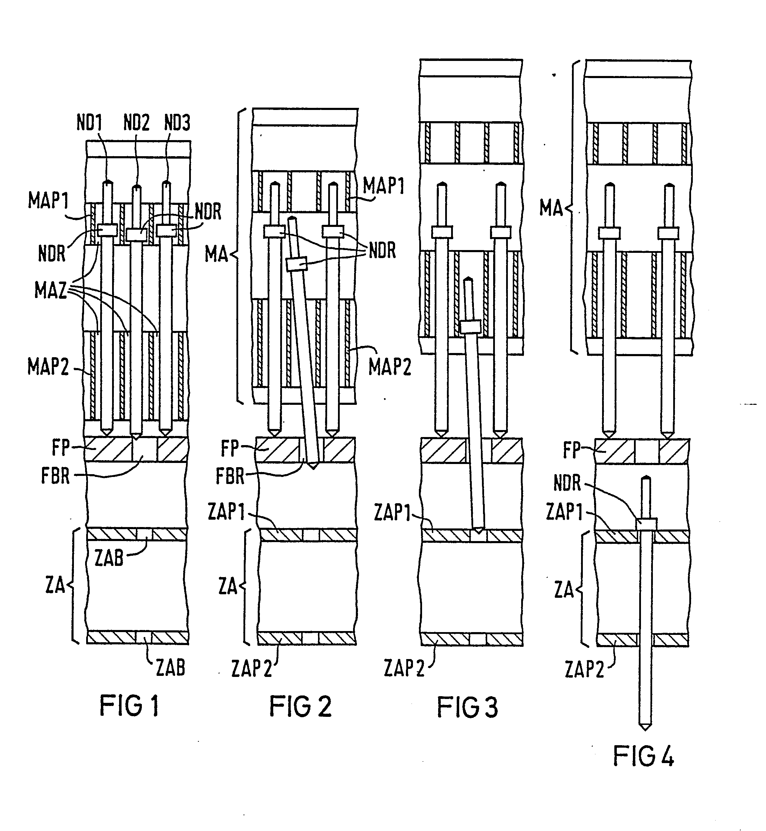

Figur 1 zeigt einen Ausschnitt aus einem Querschnitt durch ein Kontaktnadelmagazin MA, eine Führungsplatte FP und einen Zwischenadapter ZA. Das Magazin MA weist eine Vielzahl von Zellen MAZ auf, in denen je eine Kontaktnadel ND1, ND2, ND3 enthalten ist. Der Zwischenadapter ZA enthält Bohrungen ZAB, die mit den Kontaktnadeln aus dem Magazin bestückt werden sollen. Nach dieser Bestückung wird der Zwischenadapter ZA in den Adapter einer Prüfeinrichtung für Leiterplatten eingebaut, die von den Kontaktnadeln an bestimmten vorgegebenen Prüfpunkten kontaktiert werden sollen. Diese Prüfpunkte liegen wie die Bohrungen zur Aufnahme von Bauelementen in einem Raster. Es kann aber nicht jeder Rasterpunkt ein Prüfpunkt sein, sondern die Prüfpunkte haben einen Mindestabstand, der gleich dem doppelten Rastermaß ist. Dies bedeutet, daß von einem Quadrupel von vier benachbarten Rasterpunkten nur einer Prüfpunkt sein kann. Dementsprechend ist im Magazin für jedes solcher Quadrupel nur eine Zelle mit einer Kontaktnadel vorgesehen. Damit ist das Magazin ausreichend bemessen, um unterschiedliche Zwischenadapter für die Prüfung von Leiterplatten mit unter schiedlichen Schaltungen und demgemäß mit unterschiedlich verteilten Prüfpunkten vollständig bestücken zu können. Die Führungsplatte FP mit den Führungsbohrungen FBR dient dazu, die aus den Zellen des Magazins fallenden Kontaktnadeln in die Bohrungen ZAB des Zwischenadapters ZA zu lenken und nicht benötigte Nadeln in den Zellen des Magazins zurückzuhalten. Magazin MA und Zwischenadapter ZA bestehen jeweils im wesentlichen aus einer oberen und einer unteren Bohrung MAP1, MAP2 bzw. ZAP1, ZAP2.

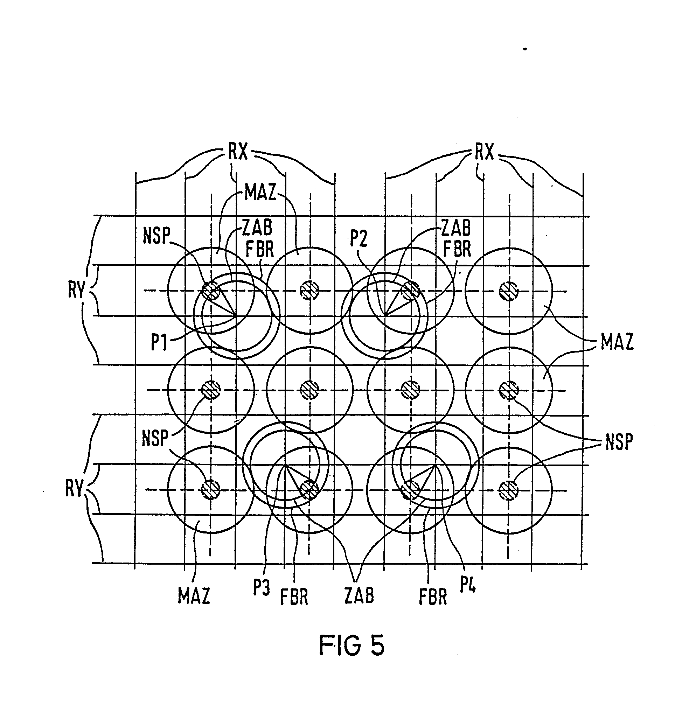

In Figur 5 sind die gegenseitigen Positionen der Zellen MAZ des Magazins, der Führungsbohrungen FBR der Führungsplatte, der Bohrungen ZBA des Zwischendapters und das Raster RX, RY der möglichen Prüfpunkte veranschaulicht, indem sie übereinander projiziert sind. Mit RX, RY sind Rasterlinien bezeichnet, an deren Schnittpunkten jeweils ein Prüfpunkt liegen kann. Der Abstand von zwei Prüfpunkten ist aber mindestens gleich dem doppelten Abstand von zwei Rasterlinien in X-oder Y-Richtung. Dies bedeutet z. B. für einen Prüfpunkt P1, daß an den diesem benachbarten acht Rasterpunkten kein Prüfpunkt liegen kann. Von diesem Gedanken ausgehend ist je einem Quadrupel von Rasterpunkten eine Magazinzelle MAZ zugeordnet. Deren Lage und Durchmesser sind so gewählt, daß die Mitten der Zellen MAZ, also dort, wo sich zunächst die mit - schraffierten kleinen Kreisen dargestellten Spitzen NSP der Kontaktnadeln befinden, in der Mitte zwischen je vier benachbarten Rasterpunkten liegt und die Zelle die vier Rasterpunkte überdeckt. Prüfpunkte P1, P2, P3, P4 liegen in den Mittelpunkten der Führungsbohrungen FBR und der Bohrungen ZAB des Zwischenadapters, wobei die Führungsbohrungen FBR einen größeren Durchmesser als die Bohrungen ZAB haben. Die Führungsbohrungen müssen nämlich so groß sein, daß die Spitzen NSP der Kontaktnadeln aus den darüberliegenden Zellen des Magazins in die Bohrungen eindringen können. Außerdem benötigen die Kontaktnadeln in den Führungsbohrungen mehr Spiel als in den Bohrungen des Zwischenadapters, wo sie möglichst spielfrei sitzen müssen. Die übereinstimmende Lage der Bohrungen FBR und ZAB hat den Vorteil, daß sie mit demselben Bohrprogramm hergestellt werden können. Es ist sogar möglich, das Bohrprogramm der zu prüfenden Leiterplatte zumindest teilweise zu verwenden.

Im folgenden wird der Bestückungsvorgang anhand der Figuren 1 bis 4 näher beschrieben. Das vollständig bestückte Kontaktnadelmagazin MA mit der Führungsplatte FP und dem Zwischenadapter ZA verbunden, wobei Führungsstifte eine exakte gegenseitige Positionierung sicherstellen. Danach wird die gesamte Anordnung um 180° gedreht, so daß die Nadeln ND1, ND2, ND3 mit den Spitzen nach unten gerichtet sind. Die Nadeln ND1, ND3 aus den Zellen, an deren zugeordneten vier Rasterpunkten kein Prüfpunkt ist, fallen nur bis zur Führungsplatte FP und sitzen auf dieser mit den Spitzen auf. Dort, wo ein Prüfpunkt vorgesehen ist, fallen die Nadeln, z. B. die der Nadel ND2, in die Führungsbohrungen FBR, können aber noch nicht durch diese fallen. Erst wenn das Magazin MA angehoben wird und dadurch die Nadeln aus den Zellen soweit nach unten rutschen, daß sie mit einem in ihrem oberen Teil vorgesehenen Ring NDR aus den Bohrungen einer oberen Magazinplatte MAP1 kommen, erhalten sie so viel horizontales Spiel, daß sie sich seitlich neigen und in die Führungsbohrungen FBR fallen können (Figur 2). Von diesen werden sie in Bohrungen in der oberen Platte ZAP1 des Zwischenadapters ZA gelenkt und fallen schließlich auch in die Bohrungen der unteren Magazinplatte ZAP2, die sie mit ihren Ringen NDR an der oberen Zwischenadapterplatte ZAP1 aufsetzen. Danach können Magazin MA und Führungsplatte FP vom Zwischenadapter ZA abgenommen und eine die elektrische Verbindungen zwischen Nadeln und Prüfgerät herstellende Kontaktplatte aufgebracht werden. Der Zwischenadapter ZA kann dann in den Adapter zur Prüfung von Leiterplatten eingesetzt werden, wobei Zwischenadapter und Leiterplatten durch Stifte gegenseitig exakt positioniert sind, so daß die Spitzen der Kontaktnadeln die Leiterplatte an den vorgesehenen Prüfpunkten berühren.

**Ansprüche**

1. Vorrichtung zum Bestücken eines Adapters mit Kontaktnadeln zum Anschluß einer Prüfeinrichtung an zu prüfende Leiterplatten, auf denen eine Vielzahl von Prüfpunkten in einem Raster angeordnet sind, wobei der Mindestabstand der Prüfpunkte gleich dem doppelten Rastermaß ist,
-mit einem Kontaktnadelmagazin (MA), in dem die Kontaktnadeln in wabenförmig angeordneten Zellen (MAZ) gelagert sind, wobei je möglichem Prüfpunkt eine Zelle mit einer Kontaktnadel (ND1, ND2, ND3) vorhanden ist und der Mittenabstand der Zellen (MAZ) gleich dem Mindestabstand der Prüfpunkte ist,
-mit einem plattenförmigen Zwischenadapter (ZA), auf dessen eine Seite die zu prüfende Leiterplatte aufsetzbar ist, der ihn senkrecht zu den beiden Flachseiten durchdringende Bohrungen (ZAB) aufweist, in welche die Kontaktnadeln (ND2) einsetzbar sind und die so angeordnet und ausgestaltet sind, daß bei aufgesetzter Leiterplatte die Kontaktnadeln die Leiterplatte an den Prüfpunkten berühren,
**gekennzeichnet durch**
-zum Einsetzen der Kontaktnadeln (ND1, ND2, ND3) ist auf den Zwischenadapter (ZA) eine Führungsplatte (FP) mit entsprechend den Prüfpunkten verteilten Führungsbohrungen (FBR) und darüber das Magazin (MA) angeordnet;
-die Zellen (MAZ) des Magazins (MA) sind so ausgestaltet, daß die Kontaktnadeln (ND1, ND2, ND3) beim Herausfallen in Richtung Führungsplatte (FP) ein seitliches Spiel erhalten, und sind so angeordnet, daß ihre Mittelachse jeweils auf die Mitte von vier möglichen Bohrungen (ZAB) im Zwischenadapter (ZA) weist,
-die Führungsbohrungen (FBR) der Führungsplatte (FP) sind so groß, daß sie die Achse der zugehörigen Zelle (MAZ) des Magazins umschließen und die Spitzen (NSP) der aus den Zellen in die Führungsbohrungen (FBR) fallenden Kontaktnadeln in die Bohrungen (ZAB) des Zwischenadapters (ZA) lenken.

2. Vorrichtung nach Anspruch 1, **dadurch gekennzeichnet,** daß der Zwischenadapter (ZA) aus zwei im Abstand voneinander angebrachten Platten (ZAP1, ZAP2) besteht.

3. Vorrichtung nach Anspruch 1 oder 2, **dadurch gekennzeichnet,** daß das Magazin (MA) aus zwei in Abstand voneinander angebrachten Platten (MAP1, MAP2) besteht und der Durchmesser der Bohrungen in der unteren Platte (MAP2) so groß ist, daß die Kontaktnadeln (ND1, ND2, ND3) nach Herausfallen aus der oberen Platte (MAP1) das seitliche Spiel erhalten.

4. Vorrichtung nach einem der Ansprüche 1 bis 3, **dadurch gekennzeichnet,** daß die Magazinzellen (MAZ) kreisförmigen Querschnitt mit einem Durchmesser haben, der etwas kleiner, vorzugsweise 10 bis 20 %, als der doppelte Mindestabstand der Prüfpunkte ist.

5. Vorrichtung nach einem der Ansprüche 1 bis 4, **dadurch gekennzeichnet,** daß der Durchmesser der Führungsbohrungen (FBR) etwas, vorzugsweise ca. 10 %, kleiner als der doppelte Mindestabstand der Prüfpunkte ist.

6. Vorrichtung nach einem der Ansprüche 1 bis 5, **dadurch gekennzeichnet,** daß der Durchmesser der Zwischenadapterbohrungen (ZAB) kleiner als der der Führungsbohrungen (FBR) und der der Zellen (MAZ) des Magazins, aber mindestens gleich dem Mindestabstand der Prüfpunkte ist.

7. Vorrichtung nach einem der Ansprüche 1 bis 6, **dadurch gekennzeichnet,** daß das Magazin (MA) gegen die Führungsplatte (FP) und den Zwischenadapter (ZA) beweglich ist.

8. Vorrichtung nach einem der Ansprüche 1 bis 7, **dadurch gekennzeichnet,** daß die Führungsplatte (FP) gegen den Zwischenadapter (ZA) beweglich ist.

FIG 1

FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | EP-A-0 144 682 (R. DEHMEL et al.) <br> * Seite 8, Zeile 20 - Seite 9, Zeile 16; Seite 11, Zeilen 19-34; Patentanspruch 1; Figuren 2,5 * | 1,2,7, 8 | G 01 R 1/073 <br> G 01 R 31/28 |
| | --- | | |
| A | EP-A-0 164 722 (T.J. BLACK) <br> * Zusammenfassung; Seite 16, Zeile 19 - Seite 17, Zeile 12; Figuren 1-3 * | 1,2,7 | |
| | --- | | |
| A | EP-A-0 149 776 (E. LUTHER et al.) <br> * Seite 14, Zeile 22 - Seite 15, Zeile 19; Patentanspruch 1; Figuren 5,6 * | 1,2 | |
| | --- | | |
| D,A | DE-C-2 920 226 (SIEMENS AG) <br> * Spalte 2, Zeile 64 - Spalte 4, Zeile 3; Figuren 1-3 * | 1,7 | RECHERCHIERTE SACHGEBIETE (Int. Cl.4) <br><br> G 01 R <br> H 01 R <br> H 05 K |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 23-06-1987 | PENZKOFER, B. |